# EUROPÄISCHE PATENTANMELDUNG

(11) **EP 1 160 844 A2**
(43) Veröffentlichungstag der Anmeldung: **05.12.2001**
(21) Anmeldenummer: 01110676.2
(22) Anmeldetag: 02.05.2001
(51) Int. Cl.: H01L 21/108

(54) **Speicherzellenanordnung**

(30) Priorität: 31.05.2000 DE 10027912
(71) Anmelder: Infineon Technologies AG, 81669 München (DE)
(72) Erfinder: Weis, Rolf, Dr., Wappingers Falls NY 12590 (US)
(74) Vertreter: Epping Hermann & Fischer

(57) **Zusammenfassung**

Eine Speicherzellenanordnung umfaßt Speicherzellen, die jeweils einen Grabenkondensator (2), der in einem Graben (4) angeordnet ist und einem vertikalen Transistor (3), der als Auswahltransistor dient, umfassen. Die Grabenkondensatoren benachbarter Speicherzellen werden neben einer Bitleitung (15) angeordnet und über ihren Auswahltransistor an die Bitleitung (15) angeschlossen. Dabei werden benachbarte Grabenkondensatoren, die an eine Bitleitung (15) angeschlossen sind, wechselseitig auf den beiden Seiten der Bitleitung (15) angeordnet.

## Beschreibung

Die vorliegende Erfindung betrifft eine Speicherzellenanordnung.

Speicherbauelemente, wie z.B. DRAMs (Dynamic Random Access Memories) bestehen aus einem Zellenfeld und einer Ansteuerungsperipherie, wobei in dem Zellenfeld einzelne Speicherzellen angeordnet sind.

Ein DRAM-Chip enthält eine Matrix von Speicherzellen, welche in Form von Zeilen und Spalten angeordnet sind und von Wortleitungen und Bitleitungen angesteuert werden. Das Auslesen von Daten aus den Speicherzellen oder das Schreiben von Daten in die Speicherzellen wird durch die Aktivierung geeigneter Wortleitungen und Bitleitungen bewerkstelligt.

Üblicherweise enthält eine DRAM-Speicherzelle einen mit einem Kondensator verbundenen Transistor. Der Transistor besteht unter anderem aus zwei Diffusionsgebieten, welche durch einen Kanal voneinander getrennt sind, der von einem Gate gesteuert wird. Abhängig von der Richtung des Stromflusses wird ein Diffusionsgebiet als Drain-Gebiet und das andere Diffusionsgebiet als Source-Gebiet bezeichnet.

Eines der Diffusionsgebiete ist mit einer Bitleitung, das andere Diffusionsgebiet mit dem Kondensator und das Gate mit einer Wortleitung verbunden. Durch Anlegen geeigneter Spannungen an das Gate wird der Transistor so gesteuert, daß ein Stromfluß zwischen den Diffusionsgebieten durch den Kanal ein- und ausgeschaltet wird.

Durch die fortschreitende Miniaturisierung von Speicherbauelementen wird die Integrationsdichte schrittweise erhöht. Die Erhöhung der Integrationsdichte bedeutet, daß die pro Speicherzelle zur Verfügung stehende Fläche immer weiter abnimmt.

Um die zur Verfügung stehende Fläche effektiv auszunutzen, kann der Auswahltransistor als vertikaler Transistor in einem Graben oberhalb eines Grabenkondensators gebildet werden. Speicherzellen mit einem Grabenkondensator und einem vertikalen Transistor ist z.B. in der Patentschrift US 5,208,657 beschrieben. Herkömmlicherweise werden dabei die Grabenkondensatoren in einem rechteckigen Muster angeordnet. Problematisch ist dabei, daß sich die Justierungenauigkeit von aufeinander folgenden photolithographischen Belichtungsebenen nachteilig auf die Funktionsfähigkeit der Speicherzellen auswirken kann.

Es ist die Aufgabe der Erfindung, eine Speicherzellenanordnung mit verbesserter Justagetoleranz für aufeinander folgende photolithographische Belichtungsebenen anzugeben.

Erfindungsgemäß wird die angegebene Aufgabe durch eine Speicherzellenanordnung gelöst mit:
- einem Substrat;
- einer ersten Speicherzelle, die in dem Substrat angeordnet ist und einen ersten Grabenkondensator und einen ersten Transistor umfaßt;
- einer zweiten Speicherzelle, die in dem Substrat angeordnet ist und einen zweiten Grabenkondensator und einen zweiten Transistor umfaßt;
- mit einer ersten Wortleitung, die an einen ersten Gate-Anschluß des ersten Transistors angeschlossen ist;
- mit einer zweiten Wortleitung, die benachbart zu der ersten Wortleitung verläuft und an einen zweiten Gate-Anschluß des zweiten Transistors angeschlossen ist;
- mit einer Bitleitung, die die erste Wortleitung und die zweite Wortleitung kreuzt und die Substratoberfläche in einen ersten Bereich und einen zweiten Bereich teilt,
- wobei die erste Speicherzelle und die zweite Speicherzelle mit der Bitleitung verschaltet sind und der größere Teil des ersten Grabenkondensators in dem ersten Bereich und der größere Teil des zweiten Grabenkondensators in dem zweiten Bereich angeordnet ist.

Der Vorteil der erfindungsgemäßen Anordnung liegt in der wechselseitigen Anordnung der Grabenkondensatoren bezüglich der Bitleitung. Üblicherweise wurden direkt benachbarte Grabenkondensatoren, die an einer Bitleitung angeschlossen sind, in einer Reihe unter bzw. auf einer Seite der Bitleitung angeordnet. Dadurch war der minimale Abstand zwischen zwei benachbarten Grabenkondensatoren relativ klein. Mit der erfindungsgemäßen Anordnung wird der Abstand benachbarter Grabenkondensatoren wesentlich vergrößert, so daß die Grabenkondensatoren in der erfindungsgemäßen Anordnung zum einen mit einem größeren Durchmesser ausgebildet werden können, so daß ihre Kapazität vergrößert ist und zum anderen eine wesentlich verbesserte Justagetoleranz gegenüber den Wortleitungen und den Bitleitungen aufweisen.

Eine vorteilhafte Ausprägung der Erfindung sieht vor, daß die Bitleitung die erste Wortleitung mit einem Winkel von 45-90° kreuzt. Durch diese Anordnung wird eine kompakte Ausgestaltung des Zellenfeldes mit optimierter Platzausnutzung der Substratoberfläche ermöglicht.

Eine weitere vorteilhafte Ausgestaltung der Erfindung sieht vor, daß die Bitleitung beim Kreuzen einer Wortleitung die Richtung ihres Verlaufs ändert. Durch diese Anordnung ist es in vorteilhafter Weise möglich, den Abstand zwischen Bitleitung und Grabenkondensator so einzustellen, daß der Bitleitungskontakt mit einer großen Justagetoleranz ausgebildet werden kann.

Weiterhin ist es vorteilhaft, daß der erste Grabenkondensator sechs nächste benachbarte Grabenkondensatoren aufweist, deren Abstände von dem ersten Grabenkondensator sich höchstens um 15% unterscheiden. Durch diese Anordnung wird der Abstand zwischen den benachbarten Grabenkondensatoren so eingestellt, daß die Substratoberfläche möglichst dicht mit Grabenkondensatoren versehen ist, die alle einen möglichst großen Abstand zu ihren nächsten benachbarten Grabenkondensatoren aufweisen und sich dadurch möglichst wenig gegenseitig beeinflussen.

Darüber hinaus ist es vorteilhaft, neben dem ersten Grabenkondensator weitere Grabenkondensatoren in den Ecken eines Hexagons anzuordnen. Die hexagonale Anordnung ist die dichteste Packung in der Ebene, so daß durch diese Anordnung eine effiziente Ausnutzung der Substratoberfläche ermöglicht wird.

Weiterhin ist es von Vorteil, daß der erste Grabenkondensator in einem unteren Bereich eines Grabens angeordnet ist und der erste Transistor als vertikaler Transistor oberhalb des Grabenkondensators in dem Graben angeordnet ist. Dadurch kann die zur Verfügung stehende Substratoberfläche weitestgehend von den Grabenkondensatoren genutzt werden und die Auswahltransistoren werden Platz sparend in dem oberen Bereich des Grabens angeordnet.

Weitere Ausgestaltungen der Erfindung sind Gegenstand der jeweiligen Unteransprüche.

Die Erfindung wird nachfolgend an Ausführungsbeispielen anhand von Figuren näher erläutert.

In den Figuren zeigen:
- Figur 1: eine Speicherzelle mit Grabenkondensator und vertikalem Auswahltransistor;
- Figur 2: eine Draufsicht auf einen Grabenkondensator;

- Figur 3: eine Draufsicht auf einen Grabenkondensator mit Bitleitung;
- Figur 4: einen Grabenkondensator mit Bitleitung und Wortleitung;
- Figur 5: die Draufsicht auf eine Anordnung von Grabenkondensatoren, Bitleitungen und Wortleitungen;
- Figur 6: die erfindungsgemäße Anordnung von Grabenkondensatoren, Bitleitungen und Wortleitungen;
- Figur 7: eine weitere Draufsicht auf eine erfindungsgemäße Anordnung von Grabenkondensatoren, Bitleitungen und Wortleitungen.

In den Figuren bezeichnen gleiche Bezugszeichen gleiche oder funktionsgleiche Elemente.

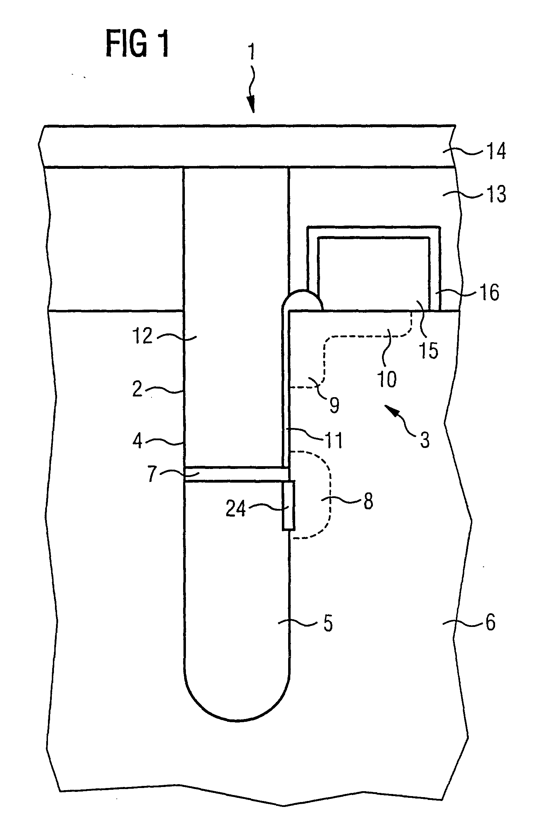

In Figur 1 ist eine Speicherzelle 1 dargestellt. Die Speicherzelle 1 besteht aus einem ersten Grabenkondensator 2 und einem ersten Transistor 3, der in diesem Ausführungsbeispiel als vertikaler Transistor ausgebildet ist. Der Transistor 3 kann beispielsweise als Stufentransistor oder auch als Rundtransistor um einen Graben gebildet werden. Der erste Grabenkondensator 2 ist in einem Graben 4 angeordnet, der seinerseits in dem Substrat 6 angeordnet ist. Der untere Bereich des Grabens 4 ist mit einer unteren Grabenfüllung 5 gefüllt. Auf der unteren Grabenfüllung 5 ist eine Isolationsschicht 7 angeordnet. An der Oberkante der unteren Grabenfüllung 5 ist seitlich neben dem Graben 4 in dem Substrat 6 ein unteres Diffusionsgebiet 8 angeordnet. Dieses Diffusionsgebiet ist eines der Source-Drain-Gebiete des vertikalen Transistors und mit einer elektrischen Verbindung 24 mit dem Kondensatorinneren verbunden . In dem oberen Bereich des Grabens 4 ist ein Gate-Oxid 11 an der Seitenwand des Grabens 4 angeordnet. Der Graben 4 ist in seinem oberen Bereich mit einem ersten Gate-Anschluß 12 gefüllt. Neben dem oberen Bereich des Grabens 4 ist ein oberes Dotiergebiet 9 angeordnet, das ebenfalls ein Source-Drain-Gebiet des vertikalen Transistors bildet. Das obere Dotiergebiet 9 ist an ein Bitleitungsdotiergebiet 10 angeschlossen, welches an der Oberfläche des Substrats 6 angeordnet ist. Auf der Oberfläche des Substrats 6, oberhalb des Bitleitungsdotiergebiets 10 ist eine Bitleitung 15 angeordnet. Die Bitleitung 15 ist von einer Bitleitungshülle 16 umgeben, die in diesem Fall isolierend ist. Oberhalb des Substrats 6 ist ein Zwischenoxid 13 angeordnet, welches aus einem isolierenden Material besteht. Auf dem Zwischenoxid 13 ist eine erste Wortleitung 14 angeordnet, die mit dem ersten Gate-Anschluß 12 verbunden ist.

Das Substrat 6 besteht beispielsweise aus dotiertem Silizium. Die untere Grabenfüllung 5 in dem Graben 4 ist beispielsweise aus einem hochdotierten Polysilizium gebildet, wobei zwischen der unteren Grabenfüllung 5 und dem Substrat 6 eine Isolationsschicht als Kondensatordielektrikum angeordnet ist. Die Isolationsschicht 7, die auf der unteren Grabenfüllung 5 angeordnet ist, besteht beispielsweise aus Siliziumoxid. Das untere Dotiergebiet 8 und das obere Dotiergebiet 9 stellen Bereiche in dem Substrat 6 dar, die eine hohe, zum Substrat komplementäre Dotierstoffkonzentration aufweisen. Das Gate-Oxid 11 ist beispielsweise aus Siliziumoxid und der erste Gate-Anschluß 12 aus einem hochdotierten Polysilizium gebildet. Das Zwischenoxid 13 besteht in diesem Ausführungsbeispiel aus einem hochdotierten Silikatglas, wie z.B. BPSG (Bor-Phosphor-Silikatglas). Die Bitleitung 15 ist beispielsweise aus einem hochdotierten Polysilizium gebildet und die erste Wortleitung 14 aus einem Metall, wie z.B. Wolfram. Die Bitleitungshülle 16 kann aus einem Siliziumnitrid hergestellt sein.

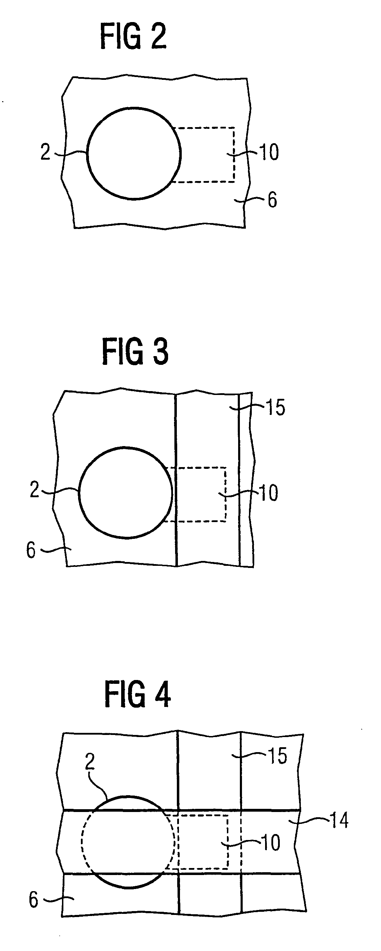

In Figur 2 ist die Draufsicht auf eine erste Speicherzelle 1 dargestellt, wobei der erste Grabenkondensator 2 und das Bitleitungsdotiergebiet 10 in dem Substrat 6 dargestellt sind.

Mit Bezug auf Figur 3 ist eine Draufsicht auf die in Figur 2 dargestellte Speicherzelle gezeigt, wobei in Figur 3 zusätzlich die Bitleitung 15 dargestellt ist, die oberhalb des Bitleitungsdotiergebietes 10 verläuft.

Mit Bezug auf Figur 4 ist die in Figur 3 angegebene Speicherzelle dargestellt, wobei zusätzlich die erste Wortleitung 14 oberhalb der Bitleitung 15 und oberhalb des Grabenkondensators 2 dargestellt ist.

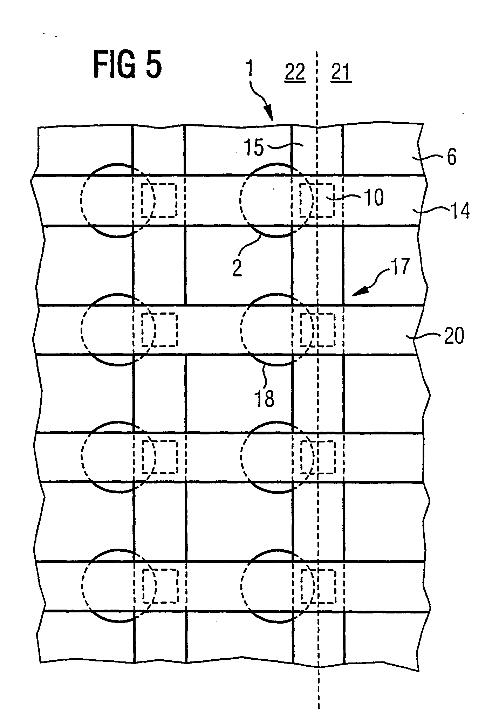

In Figur 5 ist eine erste Speicherzelle 1 und eine zweite Speicherzelle 17 dargestellt. Die erste Speicherzelle 1 weist dabei einen ersten Grabenkondensator 2 auf und die zweite Speicherzelle 17 einen zweiten Grabenkondensator 18. Die erste Speicherzelle 1 und die zweite Speicherzelle 17 sind an eine Bitleitung 15 angeschlossen, die oberhalb des Bitleitungsdotiergebietes 10 verläuft. Weiterhin teilt die Bitleitung 15 das Substrat 6 in einen ersten Bereich 21 und einen zweiten Bereich 22. In Figur 5 ist sowohl der erste Grabenkondensator 2 als auch der zweite Grabenkondensator 18 in dem zweiten Bereich 22 angeordnet. Weiterhin ist die erste Speicherzelle 1 an die erste Wortleitung 14 und die zweite Speicherzelle 17 an die zweite Wortleitung 20 angeschlossen.

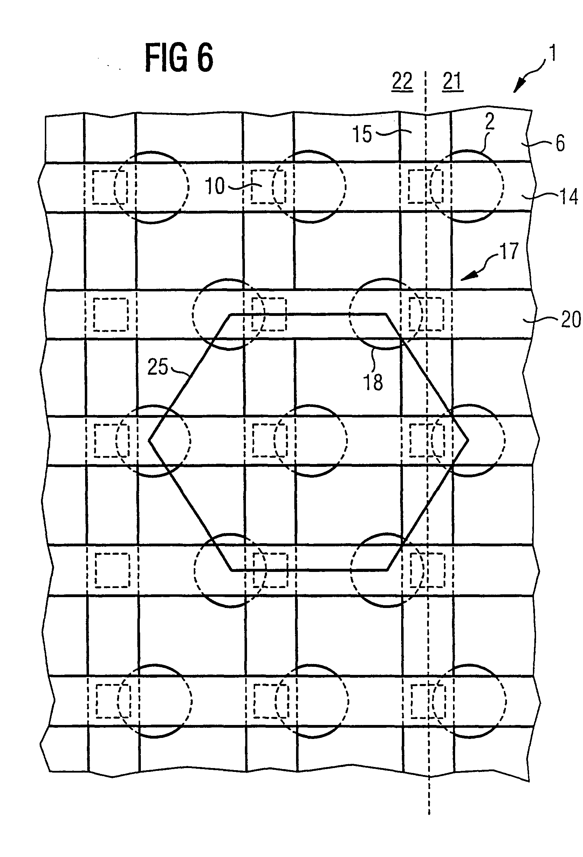

Mit Bezug auf Figur 6 ist die Draufsicht auf eine erfindungsgemäße Anordnung dargestellt. In dem Substrat 6 ist eine erste Speicherzelle 1 und eine zweite Speicherzelle 17 angeordnet. Die erste Speicherzelle weist einen ersten Grabenkondensator 2 auf, die zweite Speicherzelle weist einen zweiten Grabenkondensator 18 auf. Sowohl die erste Speicherzelle 1 als auch die zweite Speicherzelle 17 sind an eine Bitleitung 15 angeschlossen. Die Bitleitung 15 teilt das Substrat 6 in einen ersten Bereich 21 und einen zweiten Bereich 22. In Figur 6 ist der erste Grabenkondensator 2 in dem Bereich 21 und der zweite Grabenkondensator 18 in dem zweiten Bereich 22 angeordnet. Die erste Speicherzelle 1 ist an eine erste Wortleitung 14 und die zweite Speicherzelle 17 ist an eine zweite Wortleitung 20 angeschlossen, die benachbart zu der ersten Wortleitung 14 verläuft. Um eine Speicherzelle sind sechs benachbarte Speicherzellen gezeichnet, deren Grabenkondensatoren in den Ecken eines Hexagons 25 angeordnet sind. Die Anordnung in den Ecken des Hexagons 25 ist besonders günstig, da es sich dabei um die dichteste Kugelpackung in der Ebene handelt, so daß die Substratoberfläche optimal ausgenutzt wird.

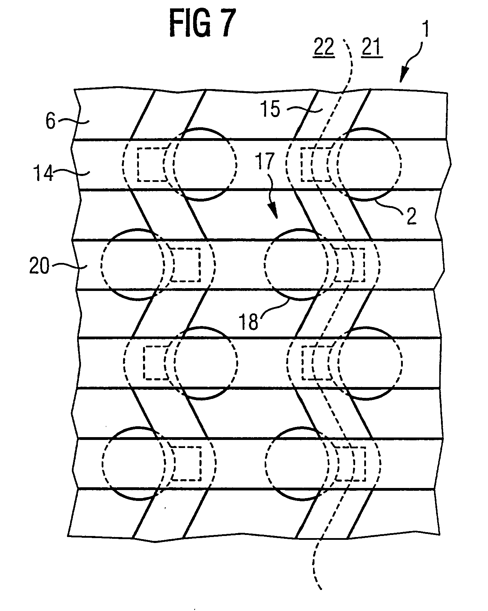

Mit Bezug auf Figur 7 ist ein weiteres Ausführungsbeispiel der erfindungsgemäßen Anordnung dargestellt. Der Unterschied zu Figur 6 besteht darin, daß die Bitleitung beim Kreuzen der ersten Wortleitung 14 einen Knick mit einem stumpfen Winkel aufweist. Zusätzlich weist die Bitleitung 15 bei dem Kreuzen jeder weiteren Wortleitung einen Knick mit einem stumpfen Winkel auf.

## Patentansprüche

1. Speicherzellenanordnung mit:
- einem Substrat (6);
- einer ersten Speicherzelle (1), die in dem Substrat (6) angeordnet ist und einen ersten Grabenkondensator (2) und einen ersten Transistor (3) umfaßt;
- einer zweiten Speicherzelle (17), die in dem Substrat (6) angeordnet ist und einen zweiten Grabenkondensator (18) und einen zweiten Transistor (19) umfaßt;
- mit einer ersten Wortleitung (14), die an einen ersten Gate-Anschluß (12) des ersten Transistors (3) angeschlossen ist;
- mit einer zweiten Wortleitung (20), die benachbart zu der ersten Wortleitung (14) verläuft und an einen zweiten Gate-Anschluß (23) des zweiten Transistors (19) angeschlossen ist;
- mit einer Bitleitung (15), die die erste Wortleitung (14) und die zweite Wortleitung (20) kreuzt und die Substratoberfläche in einen ersten Bereich (21) und einen zweiten Bereich (22) teilt,
**dadurch gekennzeichnet, daß**
die erste Speicherzelle (1) und die zweite Speicherzelle (17) mit der Bitleitung (15) verschaltet sind und der größere Teil des ersten Grabenkondensators (2) in dem ersten Bereich (21) und der größere Teil des zweiten Grabenkondensators in dem zweiten Bereich (22) angeordnet ist.

2. Speicherzellenanordnung nach Anspruch 1,
**dadurch gekennzeichnet, daß**
die Bitleitung (15) die erste Wortleitung (14) mit einem Winkel zwischen 45° bis 90° kreuzt.

3. Speicherzellenanordnung nach einem der Ansprüche 1 oder 2,
**dadurch gekennzeichnet, daß**
die Bitleitung (15) beim Kreuzen einer Wortleitung (14, 20) die Richtung ihres Verlaufs ändert.

4. Speicherzellenanordnung nach einem der Ansprüche 1 bis 3,
**dadurch gekennzeichnet, daß**
der erste Grabenkondensator (2) sechs nächste benachbarte Grabenkondensatoren aufweist, deren Abstände von dem ersten Grabenkondensator sich höchstens um 15% unterscheiden.

5. Speicherzellenanordnung nach einem der Ansprüche 1 bis 4,
**dadurch gekennzeichnet, daß**
neben dem ersten Grabenkondensator (2) weitere Grabenkondensatoren in den Ecken eines Hexagons (25) angeordnet sind.

6. Speicherzellenanordnung nach einem der Ansprüche 1 bis 5,
**dadurch gekennzeichnet, daß**
der erste Grabenkondensator (2) in einem unteren Bereich eines Grabens (4) angeordnet ist und der erste Transistor (3) als vertikaler Transistor oberhalb des Grabenkondensators (2) in dem Graben (4) angeordnet ist.
